(19) Europäisches Patentamt
European Patent Office
Office européen des brevets

(11) **EP 4 707 874 A1**

(12) **DEMANDE DE BREVET EUROPEEN**

(43) Date de publication:
**11.03.2026 Bulletin 2026/11**

(21) Numéro de dépôt: **25199552.8**

(22) Date de dépôt: **02.09.2025**

(51) Classification Internationale des Brevets (IPC):
**G01V 3/04** *(2006.01)* **G01V 3/08** *(2006.01)*

(52) Classification Coopérative des Brevets (CPC):
**G01V 3/04; G01V 3/081**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **05.09.2024 FR 2409416**

(71) Demandeur: **SKIPPER NDT**
**64000 Pau (FR)**

(72) Inventeur: **Le Gouis, Vincent**
**75002 Paris (FR)**

(74) Mandataire: **RVDB**
**85 Place Marmottan**
**BP 30247**
**62405 Béthune Cedex (FR)**

(54) **DISPOSITIF D'INJECTION D'UN COURANT AU NIVEAU D'UNE STRUCTURE MAGNÉTIQUE ET/OU MÉTALLIQUE POUR GÉNÉRER UN SIGNAL MESURABLE PAR DES CAPTEURS MAGNÉTOMÉTRIQUES ET DISPOSITIF ASSOCIÉ DE CARTOGRAPHIE POUR LE CONTRÔLE D'ÉTAT ET/OU LA GÉOLOCALISATION DE LADITE STRUCTURE**

(57) La présente invention concerne un dispositif d'injection d'un courant au niveau d'une structure magnétique et/ou métallique pour générer un signal mesurable par des capteurs magnétométriques, ainsi qu'un dispositif de cartographie associé, le dispositif d'injection comprenant : des moyens de connexion en entrée à une alimentation en courant, des moyens de connexion en sortie à des points de liaison électrique de ladite structure, un étage de conversion de la tension fournie par l'alimentation en courant comportant un inverseur et des moyens de traitement pour la génération d'une tension continue en sortie selon au moins une fréquence déterminée, un étage de filtrage pour le contrôle de l'enveloppe du courant injecté au niveau de la structure permettant d'obtenir une réponse de la structure mesurable par des capteurs magnétométriques.

[Fig. 4]

EP 4 707 874 A1

**Description**

Domaine technique

La présente invention concerne principalement un dispositif d'injection d'un courant au niveau d'une structure magnétique et/ou métallique pour générer un signal mesurable par des capteurs magnétométriques. L'invention trouvera son application dans la localisation de canalisation de type pipeline, notamment pour le transfert de liquide ou de gaz. L'invention pourra également être utilisée pour la détection et la géolocalisation d'autres types d'ouvrage ou encore dans des recherches de type géophysique. Également, l'invention pourra être utilisée dans le contrôle externe d'ouvrages à la fois pour le contrôle de l'intégrité de l'ouvrage et pour évaluer la connexion magnétique entre deux ouvrages voisins.

Arrière-plan technologique

On connaît différentes méthodes de détection utilisant des magnétomètres pour la détection de structures non visibles. Parmi ces méthodes, on connaît une première méthode dite passive dans lequel les capteurs enregistrent le signal magnétique émis par le terrain incluant les structures à détecter et une seconde méthode dite active dans laquelle on injecte un courant dans la structure pour mesurer la réponse de la structure sous tension.

La présente invention se situe dans le domaine de la détection à partir de la méthode active. Pour mettre en œuvre cette méthode active, on réalise une injection de courant au niveau d'un point de position connu de la structure. Dans le cas des canalisations ou pipelines on utilise, en général, les points de prise de potentiel ou les postes de soutirages installés lors de la pose de la canalisation ou pipeline.

Durant l'injection de courant on effectue de manière classique des mesures, notamment par balayage du secteur à contrôler, à partir de magnétomètres, puis on vient générer à partir des données collectées, combinant les mesures et le positionnement des capteurs, une carte de géolocalisation en 2D ou 3D.

Jusqu'à présent, l'injection du courant est effectuée par des générateurs de courant standard dont le but est simplement de convertir un courant en entrée pour alimenter en courant un récepteur électrique. Les caractéristiques du courant généré par ce type de générateur sont peu précises et constantes, par conséquent l'emploi de ces générateurs de courant sont sources d'erreurs pour les mesures des capteurs et leur exploitation.

Plus précisément un des problèmes de ces générateurs est que, notamment, le courant injecté n'est ni suffisant ni stable durant l'injection.

Un autre problème est que les générateurs ne peuvent varier de manière optimale la fréquence d'injection, de plus le spectre de ces fréquences est trop étendu et génère là encore des réponses des structures aléatoires engendrant des mesures non exploitables ou encore des anomalies de mesure.

Un autre problème et est que les générateurs envoient, après réglage, une tension qui ne peut être modifiée en fonction de différents paramètres tels que les dimensions du pipeline ou encore en fonction des mesures obtenues par les capteurs ou encore des interférences possibles sur le terrain.

Il résulte de ceci que les opérateurs doivent effectuer manuellement de nombreux essais avec les générateurs actuels pour obtenir des résultats, ces derniers étant de qualités insuffisantes et aléatoires.

Enfin, selon un autre aspect, les points d'injection dans la structure à étudier sont, dans la plupart des cas pratiques, en extérieur et exposés aux éléments. Les générateurs standards utilisés dans ces conditions ne sont pas adaptés, notamment l'humidité ou les chocs engendrent des dérives en fréquence du courant injecté non compensables sur le terrain.

Problème technique à résoudre

Un problème technique que se propose de résoudre la présente invention est de fournir un nouveau dispositif d'injection dans lequel les caractéristiques du courant injecté assurent une stabilité de la réponse de la structure permettant une exploitation des signaux reçus par les capteurs.

Un autre problème que se propose de résoudre la présente invention est de proposer un dispositif d'injection permettant de générer des modifications du courant en fonction des caractéristiques de la structure enterrée et/ou de la réponse magnétique de la structure.

Un autre problème que se propose de résoudre la présente invention est d'associer en temps réel la génération du courant en fonction des conditions de prises de mesures des capteurs permettant d'optimiser les données issues des mesures des capteurs et par conséquent d'améliorer la localisation des structures et/ou le diagnostic sur l'état des structures.

Un autre problème que se propose de résoudre la présente invention est, de proposer un dispositif d'injection simple à mettre en œuvre, adapté aux conditions de terrains et permettant de générer des tensions de courant jusqu'à 150 V à des fréquences précises et réglables.

Résumé de la présente invention

La présente invention concerne un dispositif d'injection d'un courant au niveau d'une structure magnétique et/ou métallique pour générer un signal mesurable par des capteurs magnétométriques.

L'invention destinée à être mise en œuvre dans le cadre d'installations électriques monophasées.

L'invention peut être portative, ou semi-portative notamment à l'aide de vecteurs tels qu'un chariot ou un drone.

Selon l'invention le dispositif d'injection d'un courant comprend :

- des moyens de connexion en entrée à une alimentation en courant,
- des moyens de connexion en sortie à des points de liaison électrique de ladite structure,
- un étage de conversion de la tension fournie par l'alimentation en courant comportant un inverseur et des moyens de traitement pour la génération d'une tension continue en sortie selon au moins une fréquence déterminée,
- un étage de filtrage pour le contrôle de l'enveloppe du courant injecté au niveau de la structure permettant d'obtenir une réponse de la structure mesurable par des capteurs magnétométriques.

Avantageusement, les moyens de filtrage peuvent comporter un premier filtrage, disposé entre l'alimentation en courant et l'étage de conversion, ledit premier filtrage comprenant au moins un condensateur permettant de limiter les variations de l'alimentation en courant et de réguler la puissance en sortie.

Préférentiellement, le premier filtrage comprend une série de condensateurs de 1 à 10 condensateurs avec des capacités de 100 à 500$\mu$F permettant de limiter les variations de l'amplitude du signal en sortie à 0,2 %.

Tout à fait préférentiellement, le premier filtrage comprend une série de 4 condensateurs avec des capacités de 350 à 500$\mu$F permettant de limiter les variations de l'amplitude du signal en sortie à 0,2 %.

Avantageusement, les moyens de filtrage peuvent inclure un second filtrage comportant un filtre en fréquences permettant la sélection d'au moins un harmonique fondamental.

Préférentiellement, le filtre en fréquences est un filtre différentiel passe bas LC, les inductances du filtre différentiel lissant le courant et le condensateur limitant les à-coups en tension.

Préférentiellement, le second filtrage permet de sélectionner au moins deux fréquences fondamentales simultanément et/ou alternativement.

Dans des variantes préférées de l'invention, les moyens de connexion, l'étage de filtrage et l'étage de conversion sont disposés dans une valise intégrant des moyens de stabilisation mécanique comportant une mousse et des amortisseurs permettant de stabiliser en température et/ou hydrométrie et/ou en position les composants électroniques dudit dispositif de contrôle.

La présente invention concerne en outre un dispositif de cartographie pour le contrôle d'état et/ou la géolocalisation d'une structure enterrée, semi-enterrée ou immergée comportant un matériau métallique ou magnétique. Le dispositif de cartographie selon l'invention comprend un dispositif d'injection de courant, un vecteur équipé de capteurs magnétométriques et de capteurs de position, ledit dispositif d'injection et ledit vecteur comportant des moyens de communication et de commande pour modifier le courant à injecter en fonction de données transmises par le vecteur au dispositif d'injection de courant.

Préférentiellement, les moyens de communication et de commande dudit dispositif de cartographie associés aux moyens de traitement permettent la modification des paramètres en fréquence et/ou en intensité du courant à injecter.

Tout à fait préférentiellement, les moyens de communication et de commande dudit dispositif de cartographie permettent la transmission de commandes de navigation du dispositif d'injection au véhicule.

Définitions

Selon la présente invention, l'expression matériau magnétique ou métallique, dans cette demande, fait référence à tout type de matériau conducteur générant un champ magnétique après injection d'un courant, et notamment englobe les matériaux de type ferromagnétiques.

Selon la présente invention, l'expression vecteur, dans cette demande, fait référence à un dispositif permettant le support et le déplacement des capteurs, il pourra s'agir notamment de manière non limitative d'un véhicule tel qu'un chariot notamment motorisé ou un drone aérien équipé d'une rampe de support de capteurs.

Brève description des figures

D'autres caractéristiques et avantages de la présente invention ressortiront de la description des exemples de réalisation particuliers et non limitatifs de la présente invention ci-après, en référence aux figures 1 à 4 annexées, sur lesquelles :

[Fig. 1] illustre schématiquement un dispositif d'injection selon un premier mode de réalisation conforme à l'invention,
[Fig. 2] représente un exemple de schéma électronique du premier filtrage selon l'invention,
[Fig. 3] illustre schématiquement un exemple de dispositif d'injection dans lequel l'étage de conversion selon l'invention est détaillé,
[Fig. 4] représente un exemple de réalisation de manière schématique du dispositif de cartographie selon l'invention
[Fig. 5] illustre schématiquement de manière plus détaillée le dispositif d'injection selon le premier mode de réalisation conforme à l'invention.

Description des exemples de réalisation

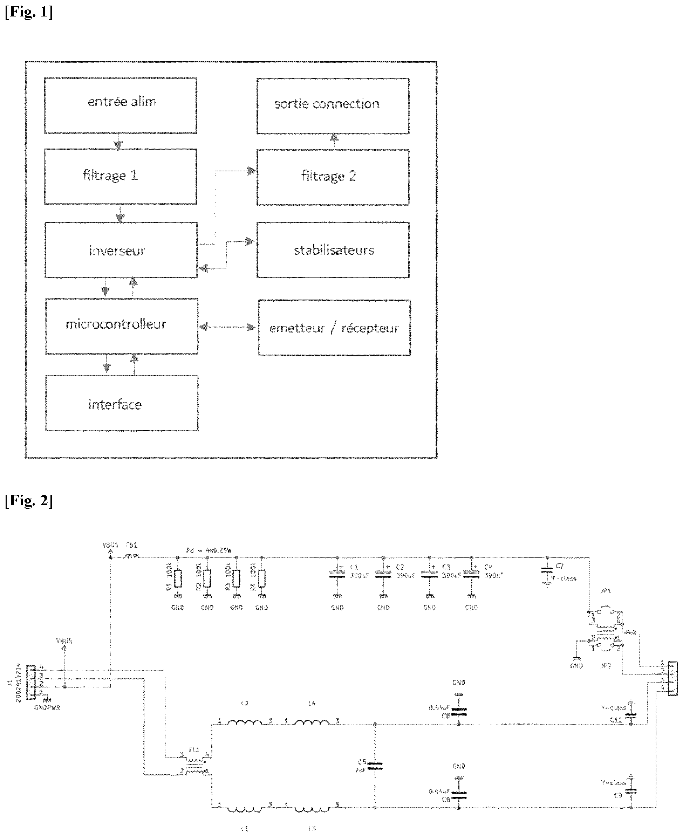

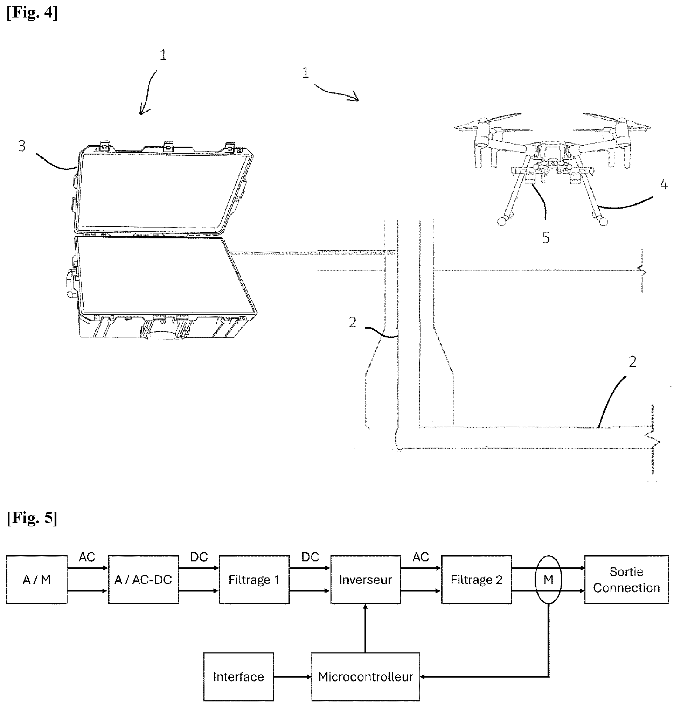

La figure 1 et la figure 5 illustrent un dispositif d'injection selon un premier mode de réalisation. Plus précisément le dispositif d'injection comprend de manière schématique des moyens de connexion en entrée à une alimentation en courant, ces moyens sont intégrés dans le bloc « entrée alimentation » de la figure 1.

Le bloc « entrée alimentation » de la figure 1 correspondant au bloc « A / AC-DC » de la figure 5, peut par exemple comprendre au moins un élément parmi : un onduleur haut fréquence, un redresseur, un filtre LC. Lorsqu'il existe, le filtre LC du bloc « entrée alimentation » permet la mise en œuvre de la technique de Zero-Voltage-Switching et permet une réduction des pertes.

Ces moyens de connexion pourront être réalisés de manière standard pour permettre le branchement à une source de courant monophasé de préférence entre 115 et 230 V pour des fréquences de 47 à 63Hz. La source de courant monophasé est illustrée à la figure 5 par le bloc « A/M».

Les blocs « stabilisateurs » et « émetteur/récepteur » ne sont pas représentés à la figure 5, en effet l'un ou l'autre de ces blocs peuvent optionnellement être mis en œuvre dans ce premier mode de réalisation de l'invention.

Le dispositif d'injection comporte en outre un étage de filtrage. Cet étage de filtrage est réalisé au moyen de deux filtres, dont un premier filtre disposé au niveau du bloc « filtrage 1 » entre le bloc « entrée alimentation » et le bloc « inverseur ». Ce premier filtre comprend au moins un condensateur permettant de limiter les variations de l'alimentation en courant et de réguler la puissance en sortie.

En se reportant cette fois à la figure 2, on voit représenté un exemple de schéma électrique de réalisation de ce premier filtre.

Ce premier filtre a pour fonction de filtrer le signal en sortie du bloc « entrée alimentation ». Il permet de limiter les variations de l'alimentation pour fournir un bus parfaitement stable. Rappelons que ce bus stable est nécessaire pour l'application spécifique de la présente invention à savoir l'injection d'un courant sur une structure pour permettre d'étudier la réponse magnétique de la structure.

Sans ce premier filtre, le bus présenterait des variations importantes engendrant des variations importantes dans l'enveloppe du courant injecté dans la structure. Or les capteurs utilisés pour la magnétométrie utilisent la réponse de la structure qui dépend de cette enveloppe. En l'absence de bus stable, le courant injecté dans la structure n'est pas suffisamment stable pour que les mesures des capteurs de magnétométrie soient exploitables. Notamment, pour pouvoir effectuer des mesures exploitables la demanderesse a déterminé, en fonction de la précision requise par les algorithmes, de l'ordre de $1\mu T$, et de la dynamique des capteurs, de l'ordre $250\mu T$, que la variation de l'enveloppe maximale admissible était de 0,2%.

Ce premier filtre permet également de fournir une puissance crête supérieure à la puissance fournie en sortie de bloc « entrée alimentation », cette caractéristique est particulièrement intéressante car la puissance instantanée devant être injectée dans les structures pour obtenir un effet mesurable par les capteurs est supérieure à celles obtenues par les réseaux électriques classiques tels que le 230V à 50Hz ou 115V à 60Hz ou par les alimentations électriques dont les autres performances (poids, dimensions) sont compatibles avec l'application.

Cette caractéristique permet de délivrer des puissances importantes nécessaires, et notamment supérieure à 2000 W, sur les structures de grandes dimensions ou celles présentant des pertes électriques importantes.

A cet effet, comme représenté à la figure 2, le premier filtre est un filtre DC comprenant un ensemble de condensateurs permettant à la fois un contrôle de la variation de la tension de sortie et la génération de puissance supérieure à celle fournie par le réseau. Ce premier filtre assure le filtrage du bus 216V en sortie de l'alimentation UHP-1500HV-230. Il comprend dans l'exemple quatre condensateurs de capacités comprises entre 350 et 500 $\mu F$ et de préférence de $390\mu F$ soit 1,56mF. Cela étant d'autres configurations jusqu'à 10 condensateurs sont envisageables avec des capacités variantes entre 100 et 500 $\mu F$. Cet ensemble, pour un signal en sortie à 10Hz pour 100Vrms et 10Arms, peut générer à son pic, 14,2A crête soit 2016W, et par conséquent plus que ce que peut fournir l'alimentation.

La puissance en sortie est dans une canalisation représentant une charge de $10\Omega$ est la suivante :

$$\text{Pinsk, max} = \text{Vrms} * \text{Irms} * 2 = 100 * 10 * 2$$

$$\text{Pinst max} = 2000\ \text{W}$$

Cet ensemble de condensateur permet en outre de limiter les variations de l'amplitude du signal en sortie à 0,2 %.

Comme représenté à la figure 1, on retrouve en sortie du bloc « filtrage 1 », les blocs « inverseur » et « microcontrôleur »

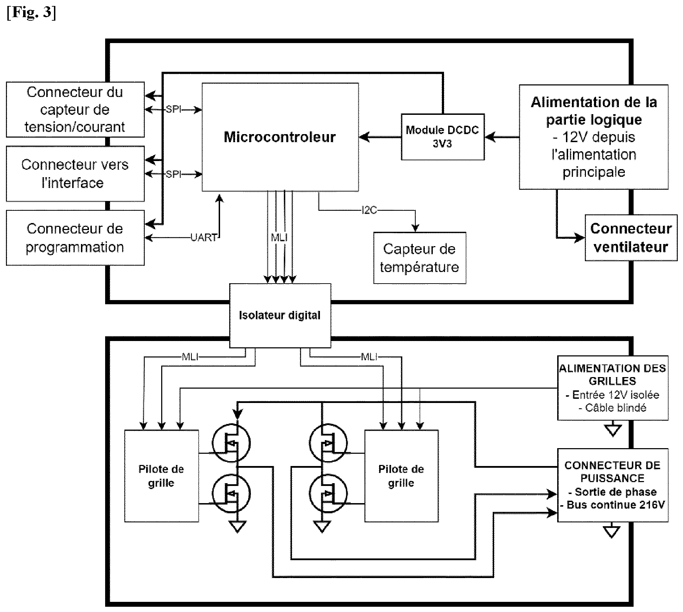

En se reportant cette fois à la figure 3 on voit représenté un exemple plus détaillé de l'inverseur et du microcontrôleur qui constituent respectivement l'étage de conversion de la tension fournie par l'alimentation en courant et les moyens de traitement pour la génération d'une tension continue en sortie selon au moins une fréquence déterminée.

Comme représenté à la figure 3, l'inverseur est de type Pur Sin. La partie puissance est dotée d'un pont en H dont le principe est de connecter la sortie au bus 216V sur une fraction du temps. En fonction de la vitesse de coupure, l'inverseur peut générer à la sortie une tension qui est une fraction de 216V. En faisant varier cette valeur moyenne selon une loi sinusoïdale on produit un signal dont le fondamental est à la fréquence de sortie désirée et dont la modulation est beaucoup plus élevée, autour de 30kHz.

La partie logique est composée d'un microcontrôleur, d'un étage d'alimentation 3,3V alimenté par la sortie auxiliaire de l'alimentation principale, d'un capteur de température et de connecteurs vers les autres cartes du système. Sa masse est reliée à la terre pour limiter les émissions électromagnétiques. Les deux parties sont isolées électriquement et un isolateur digital assure la communication à sens unique.

En fonction des applications, l'étage de conversion pourra fournir une ou plusieurs fréquences en sortie. La réponse de la structure à l'injection d'un courant sous plusieurs fréquences pourra rendre les mesures des capteurs plus efficaces, notamment si l'une des fréquences engendre une réponse dans une fréquence perturbée par l'environnement.

Selon l'invention, le microcontrôleur commande préférentiellement l'inverseur selon une modulation de largeur d'impulsions MLI (en anglais Pulse Width Modulation PWM).

Dans le mode de réalisation de la figure 3 l'inverseur étant de type Pur Sin, le microcontrôleur le commande tout à fait préférentiellement selon une modulation de largeur d'impulsions MLI d'onde sinusoïdale (en anglais Sinusoidal Pulse Width Modulation SPWM). Dans un tel mode de réalisation, le bloc « filtrage 2 » permet d'extraire du signal de sortie du pont en H la fréquence fondamentale désirée.

Pour permettre de générer plusieurs fréquences, la carte électronique de l'étage de conversion comprend une horloge 80MHz et un cristal compensé en température qui permet de limiter les variations cycle à cycle. Les moyens de traitement utilisent l'horloge pour générer en sortie de convertisseur différentes fréquences fondamentales.

Le signal en entrée du second filtre peut de la sorte avoir plusieurs fréquences fondamentales inférieures à la fréquence du filtre (1000Hz) générées par le découpage dans l'étage de conversion.

En se reportant à nouveau à la figure 1, on voit que le dispositif d'injection comprend en outre un bloc « interface » et un bloc « émetteur/récepteur »

Le bloc « interface » comprend de manière classique des moyens de commande pour l'opérateur tel qu'un clavier et/ou un écran.

Le bloc « émetteur/récepteur » comprend des moyens pour l'échange de données entre le dispositif d'injection et les capteurs de magnétométrie portés par les vecteurs. Il est important de noter que dans un premier mode de réalisation le dispositif d'injection fonctionne sans communiquer avec les capteurs, les différentes modifications au niveau du courant injecté, par exemple de fréquences ou d'amplitude sont effectués par l'opérateur, éventuellement après avoir collecté et analysé les données des capteurs ou encore en suivant une routine.

Dans ce premier mode de réalisation, ces moyens de communication sont par conséquent optionnels et ainsi le dispositif d'injection pourra ne pas comprendre de bloc « émetteur / récepteur ».

Dans un second mode de réalisation le dispositif d'injection tel que représenté à la figure 1 comprend des moyens d'émission / réception avec les capteurs d'un véhicule. Ce mode de réalisation est particulièrement intéressant puisqu'il permet de modifier différents paramètres du courant injecté en fonction des données issues des capteurs du véhicule.

En se reportant à la figure 4, on voit représenté de manière schématique un exemple de réalisation d'un dispositif de cartographie 1. Ce dispositif de cartographie 1 peut être utilisé pour le contrôle d'état et/ou la géolocalisation d'une structure enterrée 2, semi-enterrée ou immergée comportant un matériau métallique ou magnétique.

Ce dispositif de cartographie 1 comprend un dispositif d'injection 3 et au moins un vecteur 4 équipé de capteurs magnétométriques 5 et de capteurs de position 6. Le dispositif d'injection 3 et ledit vecteur 4 comportent des moyens de communication et de commande (non représentés dans la figure 4 annexée). Selon une caractéristique avantageuse de l'invention les données transmises vers le dispositif d'injection 3 permettent l'envoi de consignes par les moyens de traitement pour modifier le courant à injecter dans la structure 2.

A titre d'exemple, lorsque les données montrent une réponse trop faible de la structure à l'injection de courant, la consigne des moyens de traitement peut être de changer de fréquence et/ou d'augmenter l'intensité du courant.

A titre d'exemple, les données de positions peuvent également servir à débuter ou arrêter l'injection de courant notamment en fonction de la présence du vecteur 4 sur la zone à inspecter ou en dehors de cette zone.

Comme indiqué plus haut les moyens de communication et de commande associés aux moyens de traitement permettent la modification des paramètres en fréquence et/ou en intensité du courant à injecter. Il est également envisageable que les moyens de communication et de commande transmettent des informations à l'opérateur via l'interface lui permettant d'agir sur les paramètres du dispositif d'injection 3.

Inversement dans un troisième mode de réalisation, combinable avec les deux autres modes de réalisation précédemment décrits, les moyens de communication et de commande permettent la transmission de commandes de navigation du dispositif d'injection 3 au vecteur 4.

En se reportant à nouveau à la figure 1, on voit que le dispositif d'injection comprend également un bloc « stabilisateurs ». Selon une caractéristique avantageuse de l'invention, les moyens de connexion, l'étage de filtrage et l'étage de conversion sont disposés dans une valise intégrant des moyens de stabilisation mécanique. Ces moyens de stabilisation mécanique permettent de protéger les composants électroniques sensibles du dispositif d'injection. De manière avantageuse ces moyens de stabilisation mécaniques comportent une mousse et des amortisseurs permettant de stabiliser en température et/ou hydrométrie et/ou en position les composants électroniques dudit dispositif de contrôle. Les moyens de stabilisation comportent également une valise étanche permet d'accueillir l'ensemble des composants du dispositif d'injection de courant.

Selon l'invention, l'étage des moyens de filtrage comportent un second filtrage disposé au niveau du bloc « filtrage 2 » représenté à la figure 1. Le second filtrage est obtenu par un filtre en fréquences permettant la sélection d'au moins un harmonique fondamental.

De manière avantageuse, le filtre en fréquence est un filtre différentiel passe bas LC, les inductances du filtre différentiel lissant le courant et le condensateur limitant les à-coups en tension. Ainsi lorsque le filtre en fréquence est un filtre différentiel passe bas LC, il apporte une protection contre les pics de tension du bus DC.

De manière avantageuse on prévoit également que le second filtrage permet de sélectionner au moins deux fréquences fondamentales simultanément et/ou alternativement.

A la figure 5 est illustrée la mesure M de la tension et du courant, réellement obtenue en sortie du bloc « filtrage 2 » et qui est fournie au microcontrôleur par le capteur de courant/tension dont le connecteur est illustré à la figure 3, afin qu'il maintienne la stabilité de la norme du courant contre les changements d'impédances des structures enterrées.

En se reportant à la figure 1, on voit que le dispositif d'injection comprend en outre un bloc « sortie connexion ». Dans ce bloc « sortie connexion », on retrouve les moyens de connexion en sortie à des points de liaison électrique de la structure.

Ces moyens de connexion en sortie comportent une première sortie connectable à la terre, et une seconde à une canalisation enterrée. La charge est similaire à une impédance complexe en série avec une pile liée au contact galvanique entre l'acier et la terre. Ce dernier créer une tension de 2V environ entre ses bornes et une impédance de $1\Omega$ à $15\Omega$ selon le type de sol et de la canalisation.

Le dispositif d'injection tel que décrit permet donc de pallier les inconvénients des générateurs de courant de l'état de la technique en proposant des caractéristiques permettant un contrôle précis des paramètres de courant injecté dans la structure et, dans une variante avantageuse, des moyens de contrôle en fonction des mesures effectuées par les capteurs du véhicule.

Bien entendu, d'autres caractéristiques à la portée de l'homme du métier auraient également pu être envisagées sans pour autant sortir du cadre de l'invention tel que défini dans les revendications suivantes.

## Revendications

1.  Dispositif d'injection d'un courant au niveau d'une structure magnétique et/ou métallique pour générer un signal mesurable par des capteurs magnétométriques,
    **caractérisé en ce qu'**il comprend :

    - des moyens de connexion en entrée à une alimentation en courant,
    - des moyens de connexion en sortie à des points de liaison électrique de ladite structure,
    - un étage de conversion de la tension fournie par l'alimentation en courant comportant un inverseur et des moyens de traitement pour la génération d'une tension continue en sortie selon au moins une fréquence déterminée,
    - un étage de filtrage pour le contrôle de l'enveloppe du courant injecté au niveau de la structure permettant d'obtenir une réponse de la structure mesurable par des capteurs magnétométriques.

2.  Dispositif d'injection de courant selon la revendication précédente dans lequel les moyens de filtrage comportent un premier filtrage, disposé entre l'alimentation en courant et l'étage de conversion, ledit premier filtrage comprenant au moins un condensateur permettant de limiter les variations de l'alimentation en courant et de réguler la puissance en sortie.

3.  Dispositif d'injection de courant selon la revendication précédente dans lequel le premier filtrage comprend une série de condensateurs de 1 à 10 condensateurs avec des capacités de 100 à $500\mu F$ permettant de limiter les variations de l'amplitude du signal en sortie à 0,2 %.

4.  Dispositif d'injection de courant selon la revendication précédente dans lequel le premier filtrage comprend une série de 4 condensateurs avec des capacités de 350 à $500\mu F$ permettant de limiter les variations de l'amplitude du signal en sortie à 0,2 %.

5.  Dispositif d'injection de courant selon l'une ou l'autre des revendications 2 à 4 dans lequel les moyens de filtrage comportent un second filtrage comportant un filtre en fréquences permettant la sélection d'au moins un harmonique fondamental.

6.  Dispositif d'injection de courant selon la revendication 5 dans lequel le filtre en fréquences est un filtre différentiel passe bas LC, les inductances du filtre différentiel lissant le courant et le condensateur limitant les à-coups en tension.

7.  Dispositif d'injection de courant selon l'une ou l'autre des revendications 4 à 6 dans lequel le second filtrage permet de sélectionner au moins deux fréquences fondamentales simultanément et/ou alternativement.

8. Dispositif d'injection de courant selon l'une quelconque des revendications précédentes **caractérisé en ce que** les moyens de connexion, l'étage de filtrage et l'étage de conversion sont disposés dans une valise intégrant des moyens de stabilisation mécanique comportant une mousse et des amortisseurs permettant de stabiliser en température et/ou hydrométrie et/ou en position les composants électroniques dudit dispositif de contrôle.

9. Dispositif de cartographie pour le contrôle d'état et/ou la géolocalisation d'une structure enterrée, semi-enterrée ou immergée comportant un matériau métallique ou magnétique comportant un dispositif d'injection selon l'une quelconque des revendications 1 à 8, un vecteur équipé de capteurs magnétométriques et de capteurs de position, ledit dispositif d'injection et ledit véhicule comportant des moyens de communication et de commande pour modifier le courant à injecter en fonction de données transmises par le véhicule au dispositif de contrôle.

10. Dispositif de cartographie selon la revendication 9 précédente dans lequel les moyens de communication et de commande associés aux moyens de traitement permettent la modification des paramètres en fréquence et/ou en intensité du courant à injecter.

11. Dispositif de cartographie selon l'une des revendications 9 et 10 dans lequel les moyens de communication et de commande permettent la transmission de commandes de navigation du dispositif d'injection au véhicule.

[Fig. 1]

[Fig. 2]

[Fig. 3]

[Fig. 4]

[Fig. 5]

**Europäisches Patentamt**
**European Patent Office**
**Office européen des brevets**

## RAPPORT DE RECHERCHE EUROPEENNE

Numéro de la demande

EP 25 19 9552

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | CN 204 906 195 U (UNIV BEIJING TECHNOLOGY) 23 décembre 2015 (2015-12-23) | 1,2,5-8 | INV. G01V3/04 |
| Y | * revendication 1 *<br>* figures 1-3 *<br>* alinéa [0004] - alinéa [0005] *<br>* alinéa [0030] * | 9-11 | G01V3/08 |
| | ----- | | |
| X | CN 104 656 148 A (CHINESE ACAD INST ELECTRONICS) 27 mai 2015 (2015-05-27)<br>* alinéa [0004] - alinéa [0005] *<br>* alinéa [0011] *<br>* alinéa [0017] *<br>* alinéa [0022] *<br>* alinéa [0052] * | 1-4,8 | |
| | ----- | | |
| Y | FR 3 132 361 A1 (SKIPPER NDT [FR]) 4 août 2023 (2023-08-04)<br>* revendication 5 *<br>* figure 1 *<br>* alinéa [0045] - alinéa [0049] * | 9-11 | |
| | ----- | | |

**DOMAINES TECHNIQUES RECHERCHES (IPC)**

G01V

Le présent rapport a été établi pour toutes les revendications

| Lieu de la recherche | Date d'achèvement de la recherche | Examinateur |
|---|---|---|
| La Haye | 15 décembre 2025 | Lameloise, C |

EPO FORM 1503 03.82 (P04C02)

**ANNEXE AU RAPPORT DE RECHERCHE EUROPEENNE
RELATIF A LA DEMANDE DE BREVET EUROPEEN NO.**

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

15-12-2025

| Document brevet cité au rapport de recherche | | Date de publication | Membre(s) de la famille de brevet(s) | | Date de publication |
|---|---|---|---|---|---|
| CN 204906195 | U | 23-12-2015 | AUCUN | | |
| CN 104656148 | A | 27-05-2015 | AUCUN | | |
| FR 3132361 | A1 | 04-08-2023 | CA | 3240176 A1 | 10-08-2023 |
| | | | EP | 4473348 A1 | 11-12-2024 |
| | | | FR | 3132361 A1 | 04-08-2023 |
| | | | US | 2025138215 A1 | 01-05-2025 |
| | | | WO | 2023148057 A1 | 10-08-2023 |

EPO FORM P0460

Pour tout renseignement concernant cette annexe : voir Journal Officiel de l'Office européen des brevets, No.12/82